# EUROPÄISCHE PATENTSCHRIFT

(11) **EP 1 174 237 B1**
(45) Veröffentlichungstag und Bekanntmachung des Hinweises auf die Patenterteilung: **09.11.2005**
(21) Anmeldenummer: 01114638.8
(22) Anmeldetag: 19.06.2001
(51) Int. Cl.: B29C 45/00, H05K 5/00

(54) **Elektrisches Gerät mit einem Gehäuse aus verfestigtem polymerem Werkstoff**
Electrical apparatus with a reinforced polymer plastic housing
Appareil électrique avec boîtier en matériau polymère renforcé

(30) Priorität: 06.07.2000 DE 10032849
(43) Veröffentlichungstag der Anmeldung: 23.01.2002
(73) Patentinhaber: Carl Freudenberg KG, 69469 Weinheim (DE)
(72) Erfinder: Plötz, Stefan, 58640 Iiserlohn (DE); Quarder, Martin, 32425 Minden (DE); Schäfer, Peter, 64297 Darmstadt-Eberstadt (DE); Trogisch, Günter, 64342 Seeheim-Jugenheim (DE)

(56) Entgegenhaltungen:
- DE-A- 19 804 607
- DE-A- 19 812 880
- DE-C- 19 733 237
- PATENT ABSTRACTS OF JAPAN vol. 2000, no. 04, 31. August 2000 (2000-08-31) & JP 2000 031606 A (MATSUSHITA ELECTRIC IND CO LTD), 28. Januar 2000 (2000-01-28)

## Beschreibung

### Technisches Gebiet

Die Erfindung betrifft ein elektrisches Gerät umfassend ein Gehäuse mit einer Wand aus verfestigtem polymerem Werkstoff und zumindest ein innerhalb des Gehäuses angeordnetes, elektrisches Bauteil, das durch zumindest eine elektrische Leitung mit zumindest einem außerhalb oder innerhalb des Gehäuses angeordneten elektrischen Bauteil verbunden ist, wobei die Leitung als flexible Leiterbahn ausgebildet und zumindest teilweise in die Wand des Gehäuses eingebettet ist.

### Stand der Technik

Bei verschiedenen Einsatzgebieten von elektrischen Geräten ist das Gehäuse ein Kunststoffformteil, das zum Schutz oder als Träger für elektrische Funktionseinheiten dient. Elektrische Geräte, insbesondere solche, die in Kraftfahrzeugen eingesetzt werden, müssen schwierigen Umgebungsbedingungen standhalten können, wie Schmutz- und Staubbelastung, hohen Temperaturschwankungen, Feuchtigkeit, insbesondere Kondensationsfeuchte und als Folge davon Korrosion. Um die Zuverlässigkeit elektronischer Schaltungen, beispielsweise Platinen, zu erhöhen, ist bekannt, die elektronischen Bauelemente mit Kunststoff zu umgießen. Es ist ferner bekannt, flexible Leiterbahnen vor mechanischen Beschädigungen oder vor Oxidation dadurch zu schützen, indem man sie mit einem thermoplastischen Material hinterspritzt.

Eine Leiterplatte, bei der ein flexibler Träger mit einem thermoplastischen Material hinterspritzt wird, ist aus der Schrift EP 0 485 838 bekannt.
Ein Kunststoffformteil mit geschützter Leiterbahn ist aus der Schrift DE OS 198 12 880 bekannt. Die Leiterbahn ist zwischen einer Kunststofffolie und einer Deckfolie eingebettet. Das Kunststoffformteil kann zur elektromagnetischen Abschirmung von elektrischen Geräten verwendet werden.

In der EP 0 881 719 A2 wird eine elektrische Verbindung vorgeschlagen, bei der ein flexibler, elektrischer Leiterbahnträger an einem Verbindungsende zu einem elektrischen Bauteil fixiert und in Vergussmasse eingebettet wird.

Die DE 197 42 178 C1 offenbart ein Verfahren, bei welchem zur Herstellung einer dichten, elektrischen Leitungsdurchführung in eine Gehäusewand eine flexible Folie, die eine Leiterbahn aufweist, jeweils an der zu spritzenden Gehäuseaußenseite und der zu spritzenden Gehäuseinnenseite zwischen zwei Hälften eines Spritzwerkzeugs eingespannt und umgespritzt wird.

### Darstellung der Erfindung

Aufgabe der Erfindung ist, ein elektrisches Gerät der eingangs genannten Art mit einem Kunststoffgehäuse so anzugeben, dass elektrische Bauteile außerhalb oder innerhalb des Gehäuses, insbesondere auch feste und bewegliche Gehäuseteile, auf technisch einfache Weise elektrisch verbunden und Herstellungskosten des Gerätes verringert werden können.

Diese Aufgabe wird erfindungsgemäß bei einem elektrischen Gerät der eingangs genannten Art mit den Merkmalen von Anspruch 1 gelöst. Auf vorteilhafte Ausgestaltungen nehmen die Unteransprüche Bezug. Gemäß der Erfindung ist vorgesehen, dass die Leitung flexibel ausgebildet ist und bei der Formgebung und Verfestigung des Gehäuses zumindest teilweise in die Wand des Gehäuses eingebettet wird und dass die flexible Leiterbahn zumindest einen Teilbereich aufweist, der oberflächenbündig in die Wand eingebettet ist und zumindest ein freies Kontaktfeld vorgesehen ist. Durch Schleifkontakte kann so in einfacher Weise eine elektrische Verbindung zwischen elektrischen Bauteilen, insbesondere auch zwischen beweglichen und feststehenden Gehäuseteilen hergestellt werden. Die Erfindung macht hierbei von dem bekannten Verfahren Gebrauch, bei welchem sich die Herstellung eines elektrischen Gerätes dadurch vereinfacht, dass man die Wandung des Gehäuses als Schutzeinrichtung für eine elektrische Leitung verwendet und bereits bei der Herstellung des Kunststoffgehäuses die Leitungen darin einbettet. In der Wandung des Gehäuses verlaufende Leitungen sind vor mechanischen Beschädigungen und Feuchtigkeit besser geschützt als frei liegende Leitungen. Dies erhöht die Zuverlässigkeit des Gerätes. Von großem Vorteil ist dies bei Geräten, die in der Kraftfahrzeugtechnik eingesetzt werden. Das Gehäuse dieser Geräte besteht meist aus Gehäuseteilen mit komplexer dreidimensionaler Struktur. Durch die Erfindung ist es möglich, auch bei diesen Gehäusestrukturen die Verbindung zwischen elektrischen Bauteilen zuverlässig und gleichzeitig mit geringen Kosten herzustellen. Die elektrischen Bauteile können außerhalb oder innerhalb des Gehäuses angeordnet elektrische Schalter oder Steckverbinder sein. Steckverbinder können vorgefertigt vergossen werden. Dadurch verkürzt sich die Montagezeit. Da die Leitungsführung in der Wand erfolgt, wird Platz gespart. Durch den Wegfall von Platinen zur Leitungsführung verringert sich auch das Gewicht des Gerätes. Auch elektronische Bauelemente, die der Temperatur der Kunststoffschmelze standhalten können, können samt Verbindungstechnik in der Gehäusewand untergebracht werden.

Vorteilhaft ist, wenn die Einbettung der Leiterbahn, so wie aus dem Stand der Technik bekannt, beim Spritzgießen des Gehäuses in einem Arbeitsschritt erfolgt. Die Umhüllung der Leiter wird dadurch kostengünstig in einem Guss hergestellt. Dadurch kann das elektrische Gerät besonders kostengünstig hergestellt werden. Die flexible Leiterbahn wird in die Kavität eines Spritzgusswerkzeuges gelegt, das Werkzeug geschlossen und die Umhüllung mit der Kunststoffschmelze in einem Guss hergestellt. Nach dem Erhärten ist die flexible Leiterbahn durch die Verfestigung der Kunststoffschmelze vom polymeren Werkstoff praktisch "eingegraben". Aus der flexiblen Leitung wurde eine im Kunststoff des Gehäuses verfestigte Leitung.

Von Vorteil ist, wenn die flexible Leiterbahn zumindest zwei nebeneinander liegende Leiter umfasst. Dadurch kann die im Kunststoff der Gehäusewandung liegende Leitung mehrere Funktionseinheiten oder elektrische Bauteile verbinden. Es können kostengünstig einfache Gehäusebauteile hergestellt werden, die Hin- und Rückleiter zu Endschaltern oder Aktuatoren beinhalten.

Es ist von Vorteil, wenn die flexible Leiterbahn mit Abstandselementen versehen ist, welche einen Abstand von einer Oberfläche der Wand festlegen. Dadurch erzielt man eine definierte Lage der Leiterbahn im Gehäuse. Es wird vermieden, dass die elektrische Leitung beim Spritzgießen an die ungeschützte Oberfläche des Gehäuses kommt. Hierbei ist von Vorteil, wenn die flexible Leiterbahn mit Abbiegungen versehen ist. Diese Abbiegungen lassen sich bei der Herstellung der flexiblen Leiterbahn durch Stanzen der Trägerfolie mit geringen Kosten herstellen.

Bevorzugt ist, wenn die Leiterbahn zusätzlich zumindest ein Kontaktelement trägt, welches in die Wand eingebettet ist. Dadurch lassen sich vorgefertigte Leitungen, an deren Enden Steckverbinder vorgesehen sind, als sogenannte Inserte verarbeiten. Steckverbinder und elektrische Leitung sind damit Teil des Gehäuses des elektrischen Gerätes.

Von Vorteil ist, wenn die flexible Leiterbahn zumindest in zwei verschiedenen Teilbereichen der Wand oberflächenbündig eingebettet ist. Es können dadurch mehrere elektrische Bauteile an der Oberfläche des Gehäuses elektrisch verbunden werden.

Bevorzugt ist auch, wenn die elektrische Leitung durchgehend in einem Abstand von der Oberfläche in die Wand eingebettet ist und im wesentlichen in der Mitte der Wand verläuft. Die elektrische Leitung wird dadurch vor mechanischen Einwirkungen und vor Feuchtigkeit am besten geschützt.

Um bei komplizierten dreidimensionalen Kunststoffgehäuseteilen die Wandung zu verstärken, kann es vorteilhaft sein, wenn die elektrische Leitung eine Armierung in der Wand des Gehäuses bildet. Man kann auf einfache Weise dies dadurch erreichen, indem man die Trägerfolie und/oder die Leiterstruktur entsprechend dick und mit einer geeigneten Formgebung ausbildet. Auf diese Weise kann die Formstabilität des Kunststoffgehäuses einfach verstärkt werden. Es ist bevorzugt, wenn die Wand des elektrischen Gerätes aus thermoplastischem Kunststoff besteht. Thermoplastische Kunststoffe lassen sich durch Spritzgießen besonders gut verarbeiten. Besonders geeignet ist ein Kunststoff aus der Reihe Polyamid, Polyester, Polyurethane, Polyacetale, Polystyrole, Polyimide, Polyphenylenoxid, Polycarbonat, Polyphenylsulfid, Polypropylen sowie deren Copolymere oder Mischungen aus den genannten Polymeren.

Bevorzugt wird ein durch Spritzgießen verarbeiteter Kunststoff, dessen Erweichungstemperatur größer ist als eine Erweichungstemperatur der flexiblen Leiterbahn. Dadurch wird erreicht, dass die Haftung der Zwischenschicht, welche die Leiterstruktur mit der Trägerfolie verbindet, nicht beeinträchtigt wird.

Um ein erfindungsgemäßes elektrisches Gerät herzustellen, wird ein Verfahren mit folgenden Schritten bevorzugt:
a) Einbringen zumindest einer elektrischen Leitung in eine Kavität eines Spritzgussformwerkzeuges,
b) Einspritzen zumindest einer Kunststoffschmelze in die Kavität,
c) Erhärten des so durch Spritzgießen hergestellten Kunststoffteils,
d) Entformen des Kunststoffteils.

Durch dieses Verfahren ist es möglich, ein elektrisches Gerät mit komplexer dreidimensionaler Gehäusestruktur herzustellen, bei dem die Gehäusewandung gleichzeitig einen zuverlässigen Schutz für elektrische Verbindungsleitungen bildet. Eine flexible Leiterbahn kann in einem Arbeitsschritt durch Spritzgießen eines polymeren Werkstoffes in einem Gehäuseabschnitt integriert werden. Von Vorteil ist hierbei, wenn die flexible Leiterbahn mit Abstandselementen versehen ist. Durch diese Abstandselemente ist es möglich beim Spritzgießen einen definierten Abstand von der Kavitätsoberfläche einzuhalten. Der Verlauf der flexiblen Leiterbahn im Gehäuse kann dadurch in der Mitte der Wand vorgegeben werden, so dass die Leiterbahn vor mechanischen Einwirkungen und vor Feuchtigkeit sehr gut geschützt ist.

### Kurzbeschreibung der Zeichnungen

- Figur 1: eine vereinfachte schematische Darstellung eines Teilbereichs eines elektrischen Gerätes im Querschnitt,
- Figur 2: eine vergrößerte schematische Darstellung eines Ausschnitts aus der Gehäusewand mit einer flexiblen Leiterbahn und einem elektronischen Bauteil im Querschnitt,
- Figur 3: einen Schnitt durch eine Gehäusewand mit einer flexiblen Leiterbahn und einem Kontaktelement,
- Figur 4: einen Ausschnitt aus der Gehäusewand mit einer flexiblen Leiterbahn und einem Kontaktfeld in schematischer Darstellung.

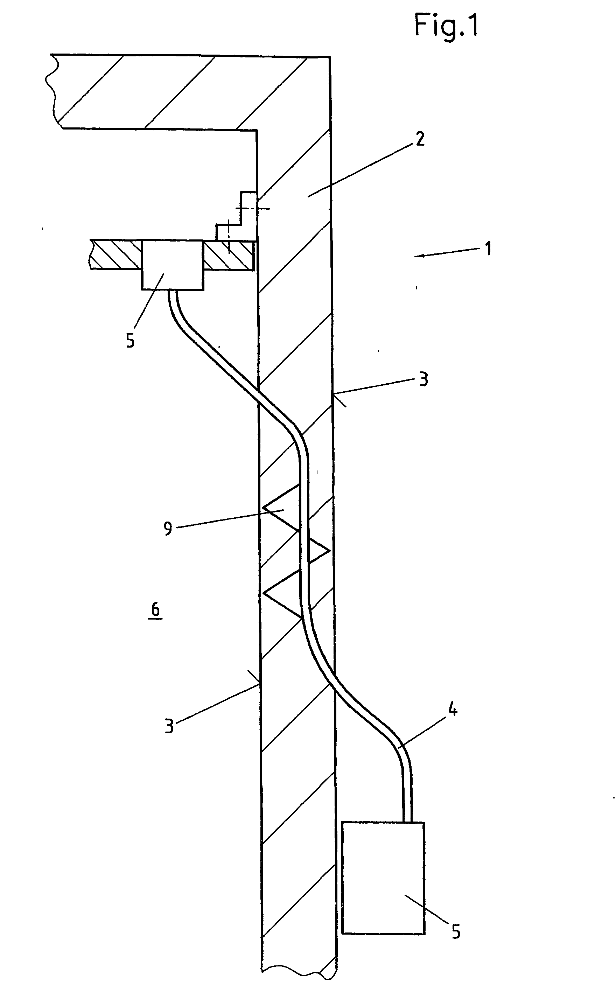

In Figur 1, 2 und 3 handelt es sich um Beispiele, die das Verständnis der Erfindung erleichtern.

In Figur 1 ist vereinfacht schematisch dargestellt, wie eine elektrische Leitung 4 Bauelemente 5 außerhalb und innerhalb eines elektrischen Gerätes 1 verbindet. Entlang eines Abschnittes ist die elektrische Leitung 4 in der Wand 2 des Gehäuses geführt. Der Abstand zur Oberfläche 3, sowohl zum Innenraum 6 als auch zur Oberfläche des Außenraums, wird durch Abstandelemente 9 vorgegeben.

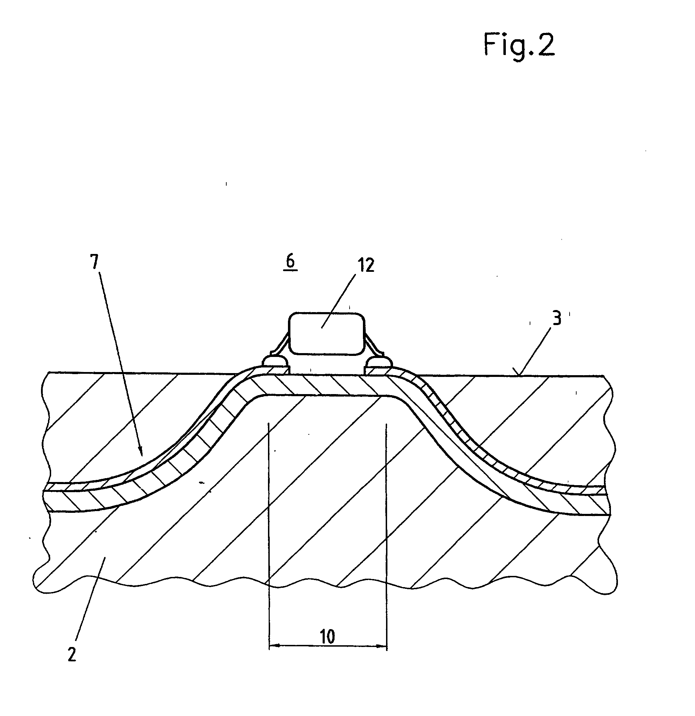

Figur 2 zeigt einen Ausschnitt aus einer Gehäusewand 2 mit einer elektrischen Leitung 7, welche in einem Teilbereich 10 oberflächenbündig in die Wand eingebettet ist. In diesem Teilbereich 10 der Oberfläche 3 ist im Innenraum 6 ein elektronisches Bauelement 12 gezeigt, welches durch Löten mit der Leiterbahn verbunden ist.

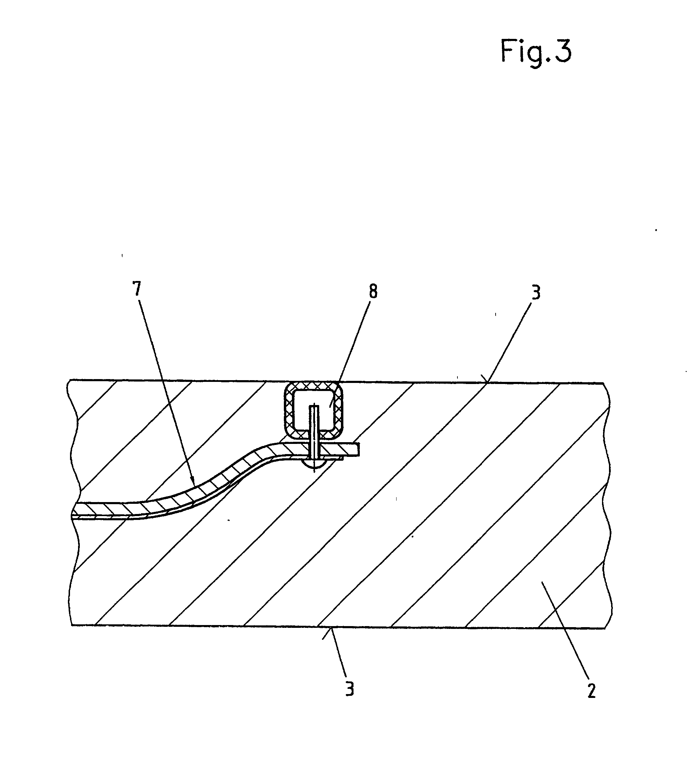

Figur 3 zeigt eine Schnittzeichnung durch eine Gehäusewand 2 mit einer etwa in der Mitte der Gehäusewand verlaufenden flexiblen Leiterbahn 7, an deren Ende ein Kontaktelement 8 angeordnet ist. Das Kontaktelement 8 schließt oberflächenbündig mit der Fläche 3 ab.

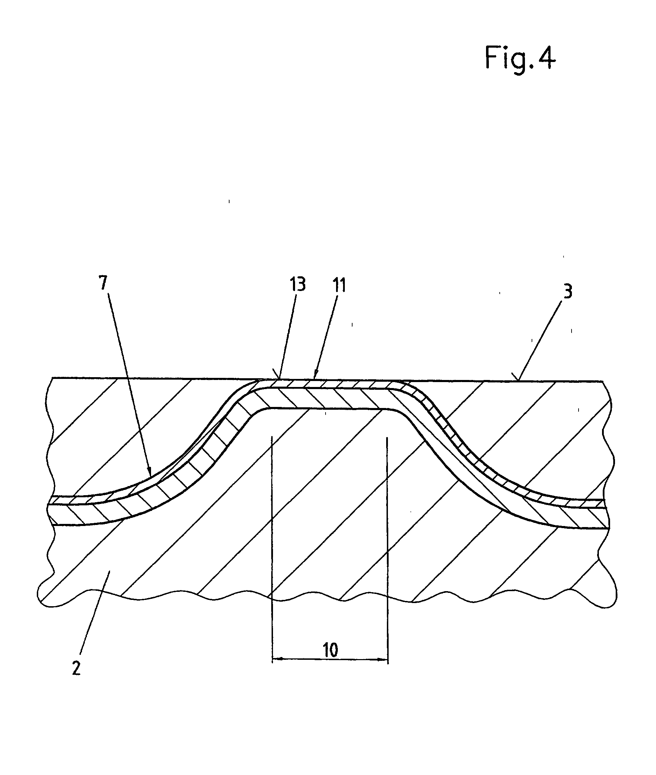

In Figur 4 ist eine flexible Leiterbahn 7 dargestellt, die in einem Teilbereich 10 ein Kontaktfeld 11 aufweist, welches bündig mit der Oberfläche 3 der Gehäusewand 2 abschließt. Auf diese Weise ist es möglich, längs des 5 Teilbereichs 10 mittels eines Schleifkontaktes 13 eine bewegliche elektrische Verbindung zu einem nicht dargestellten Bauteil herzustellen.

## Patentansprüche

1. Elektrisches Gerät, umfassend ein Gehäuse mit einer Wand (2) aus verfestigtem polymerem Werksstoff und zumindest ein innerhalb des Gehäuses angeordnetes, elektrisches Bauteil (5), das durch zumindest eine elektrische Leitung (4) mit zumindest einem außerhalb oder innerhalb des Gehäuses angeordneten elektrischen Bauteil verbunden ist, wobei die Leitung (4) flexible Leiterbahn ausgebildet und zumindest teilweise in die Wand (2) des Gehäuses eingebettet wird, **dadurch gekennzeichnet, dass** die flexible Leiterbahn (7) zumindest einen Teilbereich (10) aufweist, der oberflächenbündig in die Wand (2) eingebettet ist und zumindest ein freies Kontaktfeld (11) ausbildet.

2. Gerät nach Anspruch 1, **dadurch gekennzeichnet, dass** die Einbettung eines Längenabschnittes der flexiblen Leiterbahn in einem Arbeitsschritt durch Spritzgießen des polymeren Werkstoffes gebildet wird.

3. Gerät nach Anspruch 2, **dadurch gekennzeichnet, dass** die flexible Leiterbahn (7) zumindest zwei nebeneinander liegende Leiter umfasst.

4. Gerät nach Anspruch 2, **dadurch gekennzeichnet, dass** die flexible Leiterbahn (7) mit Abstandselementen versehen ist, welche einen Abstand von einer Oberfläche (3) der Wand festlegen.

5. Gerät nach Anspruch 4, **dadurch gekennzeichnet, dass** die flexible Leiterbahn (7) mit Abbiegungen (9) versehen ist.

6. Gerät nach Anspruch 2, **dadurch gekennzeichnet, dass** die flexible Leiterbahn (7) zumindest ein Kontaktelement (8) trägt, welches in die Wand (2) eingebettet ist.

7. Gerät nach Anspruch 2, **dadurch gekennzeichnet, dass** die flexible Leiterbahn (7) zumindest in zwei verschiedenen Teilbereichen der Wand (2) oberflächenbündig eingebettet ist.

8. Gerät nach Anspruch 2, **dadurch gekennzeichnet, dass** die flexible Leiterbahn durchgehend in einem Abstand zur Oberfläche in die Wand eingebettet ist und im wesentlichen in der Mitte der Wand verläuft.

9. Gerät nach Anspruch 1, **dadurch gekennzeichnet, dass** die Leitung (4) eine Armierung in der Wand (2) des Gehäuses bildet.

10. Gerät nach Anspruch 1, **dadurch gekennzeichnet, dass** die Wand (2) aus thermoplastischem Kunststoff besteht.

11. Gerät nach Anspruch 10, **dadurch gekennzeichnet, dass** die Erweichungstemperatur der flexiblen Leiterbahn größer ist als die Erweichungstemperatur des thermoplastischen Kunststoffes.

## Claims

1. Electrical device, comprising a housing having a wall (2) made from a reinforced polymeric material and at least one electrical component (5) which is arranged inside the housing and is connected to at least one electrical component, which is arranged outside or inside the housing, by at least one electrical line (4), the line (4) being in the form of a flexible conductor track and being embedded at least partially in the wall (2) of the housing, **characterized in that** the flexible conductor track (7) has at least one subregion (10) which is embedded in the wall (2) such that it is flush with the surface and forms at least one free contact area (11).

2. Device according to Claim 1, **characterized in that** the embedding of a section of length of the flexible conductor track is formed in one working step by injection moulding the polymeric material.

3. Device according to Claim 2, **characterized in that** the flexible conductor track (7) comprises at least two adjacent conductors.

4. Device according to Claim 2, **characterized in that** the flexible conductor track (7) is provided with spacer elements which fix a distance from a surface (3) of the wall.

5. Device according to Claim 4, **characterized in that** the flexible conductor track (7) is provided with bent-back sections (9).

6. Device according to Claim 2, **characterized in that** the flexible conductor track (7) bears at least one contact element (8) which is embedded in the wall (2).

7. Device according to Claim 2, **characterized in that** the flexible conductor track (7) is embedded at least in two different subregions of the wall (2) such that it is flush with the surface.

8. Device according to Claim 2, **characterized in that** the flexible conductor track is embedded in the wall continuously at a distance from the surface and extends essentially in the centre of the wall.

9. Device according to Claim 1, **characterized in that** the line (4) forms a reinforcement in the wall (2) of the housing.

10. Device according to Claim 1, **characterized in that** the wall (2) is made from a thermoplastic.

11. Device according to Claim 10, **characterized in that** the softening point of the flexible conductor track is greater than the softening point of the thermoplastic.

## Revendications

1. Appareil électrique, comprenant un boîtier avec une paroi (2) en matériau polymère renforcé et au moins un composant électrique (5) disposé à l'intérieur du boîtier, qui est raccordé par au moins une ligne électrique (4) à au moins un composant électrique disposé à l'extérieur ou à l'intérieur du boîtier, dans lequel la ligne (4) forme une voie conductrice flexible et est noyée au moins partiellement dans la paroi (2) du boîtier, **caractérisé en ce que** la voie conductrice flexible (7) présente au moins une zone partielle (10), qui est noyée à fleur de la surface dans la paroi (2) et forme au moins un champ de contact libre (11).

2. Appareil selon la revendication 1, **caractérisé en ce que** l'enrobage d'une partie de la longueur de la voie conductrice flexible est formé en une opération de moulage par injection du matériau polymère.

3. Appareil selon la revendication 2, **caractérisé en ce que** la voie conductrice flexible (7) comprend au moins deux conducteurs placés l'un à côté de l'autre.

4. Appareil selon la revendication 2, **caractérisé en ce que** la voie conductrice flexible (7) est pourvue d'éléments d'écartement, qui fixent une distance à partir de la surface (3) de la paroi.

5. Appareil selon la revendication 4, **caractérisé en ce que** la voie conductrice flexible (7) est pourvue de pièces pliées (9).

6. Appareil selon la revendication 2, **caractérisé en ce que** la voie conductrice flexible (7) porte au moins un élément de contact (8), qui est noyé dans la paroi (2).

7. Appareil selon la revendication 2, **caractérisé en ce que** la voie conductrice flexible (7) est noyée à fleur de la surface dans au moins deux zones partielles différentes de la paroi (2).

8. Appareil selon la revendication 2, **caractérisé en ce que** la voie conductrice flexible est noyée en continu dans la paroi à une certaine distance de la surface et est posée sensiblement au milieu de la paroi.

9. Appareil selon la revendication 1, **caractérisé en ce que** la ligne (4) forme une armature dans la paroi (2) du boîtier.

10. Appareil selon la revendication 1, **caractérisé en ce que** la paroi (2) se compose de matière plastique thermoplastique.

11. Appareil selon la revendication 10, **caractérisé en ce que** la température de ramollissement de la voie conductrice flexible est supérieure à la température de ramollissement de la matière plastique thermoplastique.
